# FASCICULE DE BREVET EUROPEEN

(11) **EP 0 913 948 B1**
(45) Date de publication et mention de la délivrance du brevet: **16.04.2003**
(21) Numéro de dépôt: 98402689.8
(22) Date de dépôt: 28.10.1998
(51) Int. Cl.: H03L 7/26

(54) **Procédé de contrôle de l'amplitude du signal micro-onde appliqué à une horloge atomique et dispositif d'asservissement pour la mise en oeuvre de ce procédé**
Amplitudensteuerverfahren für Atomuhr-Mikrowellensignal und Verriegelungseinrichtung zur Implementierung Verfahrens
Microwave signal amplitude control method for an atomic clock and locking device for implementing the method

(30) Priorité: 29.10.1997 FR 9713572
(43) Date de publication de la demande: 06.05.1999
(73) Titulaire: Tekelec Temex, 92310 Sevres (FR)
(72) Inventeur: Audoin, Claude, 92290 Chatenay-Malabry (FR); Hamouda, Frédéric, Clair Village, 91600 Savigny Sur Orge (FR); Chassagne, Luc, 75014 Paris (FR); Barillet, Roland, 91190 Gif Sur Yvette (FR)
(74) Mandataire: Berger, Helmut

(56) Documents cités:
- EP-A- 0 526 073
- US-A- 4 331 933
- US-A- 4 943 955

## Description

L'invention concerne un procédé de contrôle de l'amplitude du signal micro-onde appliqué à une horloge atomique du type comportant un résonateur atomique et un dispositif d'asservissement d'un oscillateur ultra-stable sur la résonance atomique, adaptée pour produire le signal duquel est dérivé ledit signal micro-onde, et un dispositif d'asservissement pour la mise en oeuvre de ce procédé.

On connaît déjà un procédé et un dispositif de ce type, voir par exemple la demande de brevet européen EP-A-0 526 073.

Il est connu que, lorsque la fréquence du signal micro-onde appliquée au résonateur atomique est égale à fₒ ± fₘ (fₒ étant la fréquence de la résonance atomique), la réponse du résonateur présente des extremums quand l'amplitude du signal micro-onde est variée, ce qui permet d'asservir l'amplitude du signal micro-onde sur une valeur qui ne dépend que des propriétés du résonateur, lesquelles sont quasi-insensibles aux perturbations ambiantes telles que par exemple la température. C'est l'extremum le plus marqué, le premier maximum en l'occurence, qui est mis à profit.

Or, dans le cas d'une horloge à jet de césium, la réponse atomique n'est pas symétrique par rapport à une verticale passant par le maximum, lorsque l'abscisse est proportionnelle à l'amplitude du signal. Dans ce cas, le maximum ne peut être obtenu avec une bonne exactitude que si la profondeur de la modulation de l'amplitude micro-onde est petite. Le signal d'erreur qui permet de contrôler la valeur de l'amplitude est alors obtenu avec un faible rapport signal sur bruit, ce qui impose une modulation permanente de l'amplitude.

Par conséquent, les procédés et dispositifs connus, du type indiqué plus haut, effectuent une modulation peu marquée de l'amplitude du signal micro-onde, qui est appliqué en permanence. Cette technique présente l'inconvénient que la modulation d'amplitude et la modulation de fréquence sont entremêlées, ce qui créé des conditions très, sinon trop complexes, notamment dans le cas d'une horloge à jet de césium à pompage optique.

La présente invention a pour but de proposer un procédé et un dispositif du type indiqué plus haut, qui pallient les inconvénients de l'état de la technique.

Pour atteindre ce but, le procédé selon l'invention est caractérisé en ce que l'on transforme l'amplitude du signal micro-onde, avant son application au résonateur à jet atomique, selon une loi telle que la forme de la courbe de réponse atomique en fonction de l'amplitude transformée soit symétrique sur une large extension autour de la verticale passant par le maximum de la réponse.

Selon une caractéristique de l'invention, la modulation de l'amplitude du signal micro-onde appliqué au résonateur est profonde, la profondeur de modulation pouvant aller jusqu'à quelques dB de la valeur médiane.

Selon une autre caractéristique de l'invention, la modulation est appliquée de façon discontinue, le choix de l'intervalle de temps entre deux réglages successifs de l'amplitude du signal micro-onde étant guidé par l'inertie de l'horloge atomique vis-à-vis des perturbations de son environnement.

Selon encore une autre caractéristique, pour un résonateur à pompage optique, la loi de transformation est une loi logarithmique.

L'invention sera mieux comprise et d'autres buts, caractéristiques, détails et avantages de celle-ci apparaîtront plus clairement dans la description explicative qui va suivre faite en référence aux dessins schématiques annexés donnés uniquement à titre d'exemple illustrant un mode de réalisation de l'invention et dans lesquels :

La figure 1 représente un diagramme de la réponse d'un résonateur à jet atomique en fonction de la fréquence du signal micro-onde appliqué au résonateur, autour de la fréquence de résonance, le déphasage entre les deux champs oscillants étant dans cet exemple égal à π.

La figure 2 représente le diagramme de la réponse du résonateur en fonction de l'amplitude du signal appliqué au résonateur.

La figure 3 représente le diagramme de la réponse du résonateur en fonction du logarithme de l'amplitude du signal micro-onde.

La figure 4 représente le chronogramme des asservissements successifs de la fréquence de l'oscillateur ultra-stable et de l'amplitude du signal micro-onde.

La figure 5 illustre la structure d'une horloge atomique pourvue d'un dispositif d'asservissement selon la présente invention.

L'invention sera décrite ci-après dans son application à une horloge atomique comportant un résonateur à jet de césium à pompage optique. Cette application n'est cependant décrite qu'à titre d'exemple et n'est pas limitative.

En se référant à la figure 5, on constate qu'une horloge atomique comporte un résonateur atomique indiqué en 1 et un dispositif "électronique" 2 destiné à asservir un oscillateur ultra-stable 3 sur la résonance atomique. Etant donné que la structure du résonateur ne fait pas partie de l'invention elle ne sera pas décrite ici, mais sa description se trouve dans le brevet français N° 2 688 632 appartenant de la demanderesse.

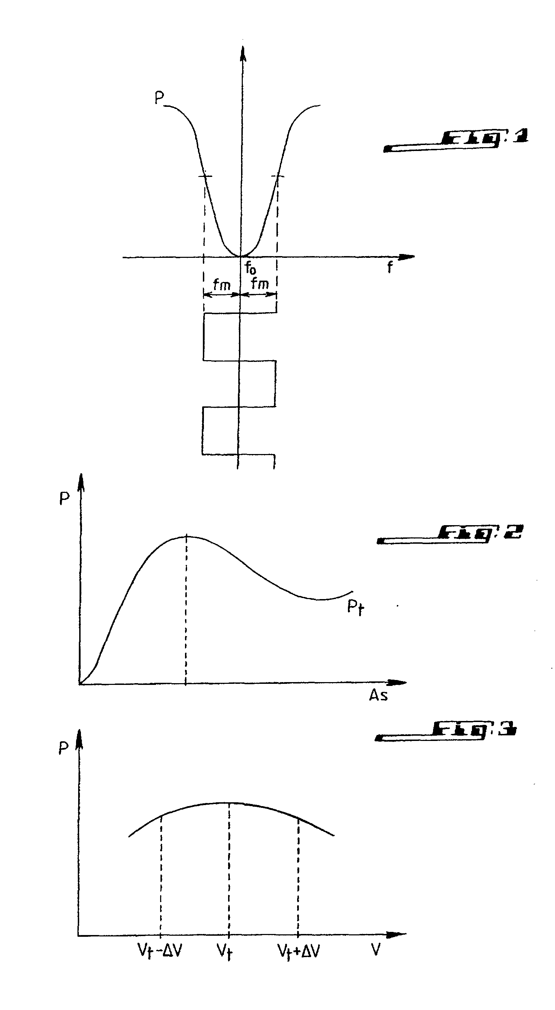

Afin d'asservir l'oscillateur 3, on applique au résonateur 1 un signal micro-onde S dont la fréquence f varie périodiquement. En régime établi, la fréquence appliquée est égale à fₒ - fₘ pendant une demi-période de modulation et fₒ + fₘ pendant la demi-période suivante, comme l'illustre la figure 1. La valeur de fₘ est voisine de la demi-largeur de la résonance atomique. La fréquence fₒ est égale à la fréquence de résonance atomique et on constate que la réponse du résonateur est la même à fₒ - fₘ et à fₒ + fₘ. La fréquence de l'oscillateur ultra-stable 3 est asservie en conséquence.

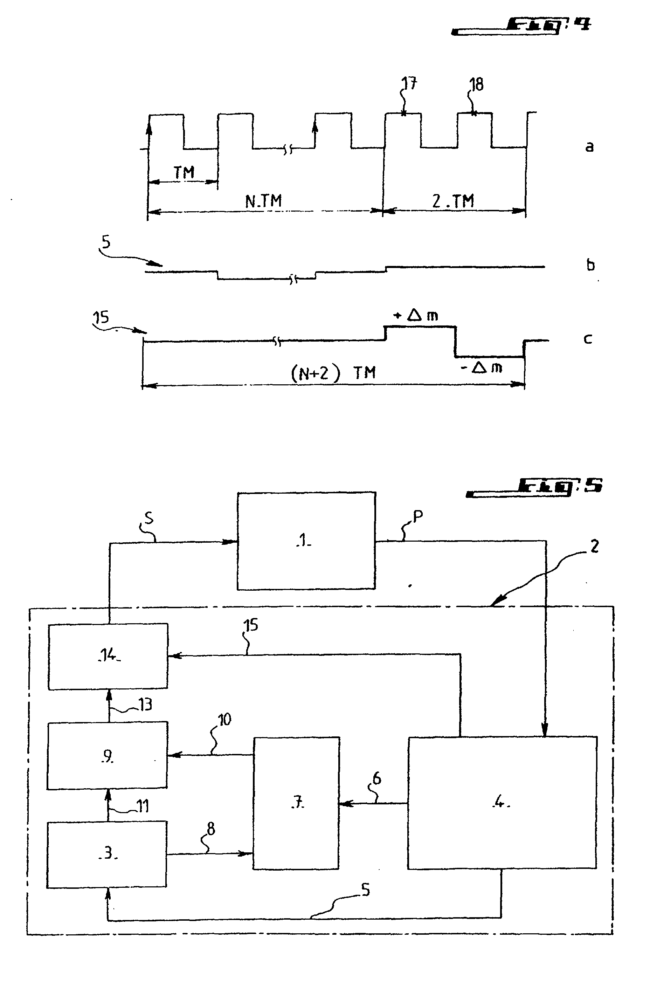

Il est connu que, lorsque la fréquence du signal micro-onde S appliqué est égale à fₒ ± fₘ, la réponse du résonateur 1 présente des extremums lorsque l'amplitude du signal micro-onde varie. La figure 2 montre ainsi que la courbe de réponse atomique P n'est pas symétrique par rapport à une verticale passant par le maximum, lorsque l'abscisse est proportionnelle à l'amplitude du signal micro-onde As. Dans ce cas, le maximum ne peut être obtenu avec une bonne exactitude que si la profondeur de la modulation de l'amplitude micro-onde est petite. La méthode d'asservissement effectuée à cette fin est semblable en son principe à celle indiquée sur la figure 1 en remplaçant la grandeur fréquence par la grandeur amplitude. Cette méthode est employée dans l'état de la technique, comme il a été expliqué plus haut. Or, dans ce cas, le signal d'erreur qui permet de contrôler la valeur de l'amplitude n'est obtenu qu'avec un faible rapport signal sur bruit, ce qui impose donc une modulation permanente de l'amplitude.

Un aspect primordial de la présente invention est fondé sur la découverte que dans un diagramme où l'abscisse est proportionnelle au logarithme de l'amplitude du signal micro-onde, la variation de la réponse atomique P devient symétrique sur une large extension de 1 à 3 dB par exemple autour de la verticale passant par le maximum Pₒ à la valeur Vₜ de la tension contrôlant l'amplitude de telle sorte que l'on obtienne un diagramme où l'abscisse est comme l'illustre la figure 3. Grâce à cette symétrie, la modulation de l'amplitude peut alors être profonde, la profondeur pouvant aller jusqu'à quelques dB comme cela vient d'être énoncé. Le rapport signal sur bruit devient alors très satisfaisant et la modulation peut être appliquée de façon discontinue. Le choix de l'intervalle de temps entre deux réglages successifs de l'amplitude micro-onde est choisi en fonction de l'inertie de l'horloge dans son ensemble, vis-à-vis des perturbations de son environnement. Pour réaliser la symétrie selon la figure 3, on applique au résonateur un signal micro-onde S dont l'amplitude est une fonction exponentielle de la tension de commande 15 produite par l'unité 4.

Comme on l'expliquera plus loin, en se référant à la figure 4, on alterne les intervalles de temps pendant lesquels l'asservissement de la fréquence de l'oscillateur 3 est activé et des intervalles de temps plus courts pendant lesquels l'asservissement de l'amplitude est réalisé. Les tensions de commande de la fréquence de l'oscillateur ou de l'amplitude du signal micro-onde sont bloquées pendant les intervalles de temps où les asservissements correspondants sont inactifs.

L'asservissement de l'amplitude du niveau micro-onde stabilise les déplacements de fréquence dont la valeur dépend de ce niveau (par exemple : effet Doppler du 2ème ordre ou effet d'un écart résiduel par rapport à la valeur 0 ou π du déphasage entre les deux champs oscillants auxquels les atomes de césium sont soumis dans le résonateur atomique).

Or, il existe une valeur de l'amplitude micro-onde telle que s'il y a un petit déséquilibre entre les valeurs de cette amplitude associée à f₀ - fₘ, d'une part, et à f₀ + fₘ, d'autre part, il n'en résulte pas d'erreur sur le pointé de la fréquence de la résonance atomique. Un tel déséquilibre peut provenir d'une imperfection de la génération et de la transmission du signal micro-onde ou d'un désaccord de la cavité résonante, c'est-à-dire lorsque la fréquence d'accord de la cavité est différente de la fréquence de la résonance atomique. Dans ce dernier cas, à un niveau d'entrée identique du signal micro-onde, aux fréquences f₀ - fₘ et f₀ + fₘ, il correspond une amplitude différente du champ dans la cavité - et donc interagissant avec les atomes - aux deux fréquences f₀ ± fₘ appliquées.

L'amplitude micro-onde qui supprime ces deux déplacements de fréquence est celle qui correspond à un extremum de la réponse atomique lorsque la fréquence appliquée est égale à f₀ ± fₘ.

En se référant à la figure 5 on décrira ci-après le dispositif d'asservissement qui permet la mise en oeuvre du procédé selon l'invention, qui vient d'être décrit en se reportant aux figures 1 à 3.

On constate que la réponse Pₜ est appliquée à une unité d'acquisition, de calcul et de commande indiquée en 4 qui, d'une part commande la fréquence de l'oscillateur ultra-stable 3, en 5, et produit un signal de commande de fréquence ajustable 6 à destination d'une unité de synthèse de fréquence ajustable 7. Celle-ci est reliée en 8 à l'oscillateur 3 et commande une unité de synthèse micro-onde 9, en 10, cette unité 9 recevant en 11 le signal produit par l'oscillateur 3. L'unité 9 est reliée en 13 à une unité à gain ajustable 14 et qui effectue aussi l'opération de symétrisation de la courbe de réponse du résonateur en transformant en conséquence l'amplitude du signal micro-onde en provenance de l'unité de synthèse 9, qui constitue le signal S appliqué au résonateur 1. Dans ce présent exemple, l'amplitude du signal micro-onde est une fonction exponentielle de la tension de commande 15. Pour l'ajustage du gain, l'unité 4 envoie en 15 à l'unité 14 un signal de commande d'amplitude.

Le fonctionnement du dispositif d'asservissement 2 ressort du diagramme présenté sur la figure 4.

Cette figure présente en a la modulation carrée de la fréquence du signal micro-onde. La modulation de fréquence est appliquée en permanence et chaque asservissement occupe un nombre entier de périodes de modulation TM. Selon la figure 4c, la tension de commande de la fréquence de l'oscillateur ultra-stable 3 assurant l'asservissement de celui-ci sur la fréquence du résonateur, occupe N périodes TM, au cours desquelles la tension est fluctuante. A cet intervalle d'asservissement de l'oscillateur suit un intervalle de deux périodes TM d'asservissement d'amplitude, avec acquisition aux niveaux correspondant aux tensions de commande Vₜ + ΔV et Vₜ - ΔV, par exemple, en 17 et 18. La figure 4 montre en c la courbe de la tension de commande de la puissance micro-onde et on constate que cette tension de commande est augmentée de + Δm et - Δm pendant l'intervalle d'asservissement d'amplitude, alors qu'elle est constante pendant la durée de l'asservissement en fréquence.

La présente invention vient d'être décrite dans son application à un résonateur à jet de césium à pompage optique. Il est évident que l'invention est applicable en d'autres cas, la symétrisation pouvant alors requérir une loi différente de la loi logarithmique du présent exemple.

On indiquera, également à titre d'exemples non limitatifs, un certain nombre de dispositifs du domaine d'application de l'invention :
- Toute espèce atomique (césium, rubidium, etc.), ionique (ion mercure, etc.) ou moléculaire pouvant donner lieu à la réalisation d'un étalon de fréquence ou d'un dispositif exploitant les méthodes d'observations précisées ci-après. Par simplicité les atomes ou ions ou molécules utilisés seront dénommés "atomes".
- En général, tout étalon de fréquence ou dispositif où la réponse des "atomes" présente un extremum lorsque la fréquence appliquée est égale à la fréquence de résonance des "atomes" plus ou moins un décalage égal, en ordre de grandeur, à la demi-largeur de la résonance des "atomes".

Cette résonance peut être due à une excitation dans n'importe quelle partie du spectre électromagnétique (micro-onde ou optique, par exemple).
- Etalon de fréquence ou dispositif utilisant un flux continu ou discontinu d'"atomes" dans lesquels l'interaction entre les "atomes" et le rayonnement électromagnétique s'effectue dans une seule région de l'espace (méthode de Rabi et ses variantes) ou dans deux (méthode de Ramsey et ses variantes) ou plusieurs zones disjointes réparties le long de la trajectoire des "atomes". Dans ces dispositifs, la succession des interactions résulte du mouvement des "atomes". Trois exemples de ces dispositifs sont les suivants : a) horloge à atomes de césium issus continûment d'un four à une température voisine de l'ambiante (∼ 80 à 100°C),b) l'horloge à atomes de césium refroidis par irradiation laser, tombant continûment ou par paquets sous l'effet de la pesanteur, et interagissant avec le champ micro-onde dans une, deux ou plusieurs zones, c) fontaine à atomes de césium refroidis par irradiation laser, où les atomes sont lancés vers le haut et effectuent une trajectoire balistique et où l'interaction avec le champ micro-onde se produit deux fois dans une seule zone de l'espace : une fois lors du trajet montant des atomes et l'autre fois lors de leur trajet descendant.
- Etalon de fréquence ou dispositif à cellule de piégeage des "atomes", quelle que soit l'origine physique du piégeage : paroi matérielle, champ électrique et/ou magnétique, interaction avec des ondes lumineuses en association ou non avec un champ magnétique.
- Etalon de fréquence ou dispositifs dans lesquels l'interaction avec le signal d'excitation électromagnétique de la résonance s'effectue dans une seule zone, mais dans lesquels un découpage temporel du signal d'excitation assure la succession désirée des interactions conduisant à l'observation de la résonance des "atomes".

## Revendications

1. Procédé de contrôle de l'amplitude du signal micro-onde appliqué à une horloge atomique du type comportant un résonateur atomique et un dispositif d'asservissement d'un oscillateur ultra-stable sur la résonance atomique, adaptée pour produire le signal duquel est dérivé ledit signal micro-onde, **caractérisé en ce que** l'on transforme l'amplitude du signal micro-onde (S), avant son application au résonateur à jet atomique (1) selon une loi telle que la forme de la courbe de réponse atomique (Pₜ) en fonction de l'amplitude du signal micro-onde (5) soit symétrique sur une large extension autour de la verticale passant par le maximum de la réponse.

2. Procédé selon la revendication 1, **caractérisé en ce que** la modulation de l'amplitude du signal micro-onde (S) appliquée au résonateur (1) est profonde, la profondeur de modulation pouvant aller jusqu'à quelques db autour de la valeur médiane.

3. Procédé selon l'une des revendications 1 ou 2, **caractérisé en ce que** la modulation est appliquée de façon discontinue, le choix de l'intervalle de temps entre deux réglages successifs de l'amplitude du signal micro-onde étant guidé par l'inertie de l'horloge atomique vis-à-vis des perturbations de son environnement.

4. Procédé selon l'une des revendications précédentes, **caractérisé en ce que**, pour un résonateur à pompage optique, la loi de transformation est une loi logarithmique.

5. Dispositif d'asservissement pour la mise en oeuvre du procédé selon l'une des revendications précédentes, comprenant un oscillateur ultra-stable (3) et une unité d'acquisition, de calcul et de commande (4) destinée à produire des signaux de commande (5, 15) pour l'asservissement du signal micro-onde sur la résonance atomique à partir de la réponse (Pₜ) du résonateur, **caractérisé en ce qu'**il comporte des moyens de transformation (14) de l'amplitude du signal micro-onde dérivé directement de l'oscillateur ultra-stable (3) pour que la courbe de la réponse (Pₜ) du résonateur soit symétrique en fonction de l'amplitude du signal micro-onde, sur une large extension autour de la verticale passant par le maximum de la réponse.

6. Dispositif d'asservissement selon la revendication 5, **caractérisé en ce qu'**il comporte des moyens de gain ajustable (14), sous la commande de l'unité d'acquisition, de calcul et de commande (4), pour la correction d'une erreur provenant de la présence de raies de résonance latérales qui encadrent la raie de résonance atomique servant de référence à l'horloge atomique.

7. Dispositif de commande selon l'une des revendications 5 ou 6, **caractérisé en ce que** les moyens de transformation précités comportent une diode PIN dans le cas d'un résonateur à jet de césium à pompage optique.

## Patentansprüche

1. Verfahren zur Regelung der Amplitude des Mikrowellensignals, welches auf eine Atomuhr des Typs angewandt wird, welcher einen Atomresonator und eine Regelungsvorrichtung eines über der Atomresonanz ultrastabilen Oszillators umfasst, ausgelegt, um das Signal zu erzeugen, von welchem das Mikrowellensignal abgeleitet ist, **dadurch gekennzeichnet, dass** man die Amplitude des Mikrowellensignals (S) vor dessen Anwendung auf den Resonator mit Atomstrahl (1) gemäß einem Gesetz derart umformt, dass die Atomantwortkurve (Pₜ) in Abhängigkeit der Amplitude des Mikrowellensignals (S) symmetrisch über eine breite Ausdehnung um die Vertikale herum ist, welche durch das Antwortmaximum verläuft.

2. Verfahren nach Anspruch 1, **dadurch gekennzeichnet, dass** die Modulation der Amplitude des Mikrowellensignals (S), welche auf den Resonator (1) angewandt wird, tief ist, wobei die Modulationstiefe bis zu einigen db um den Mittelwert herum gehen kann.

3. Verfahren nach einem der Ansprüche 1 oder 2, **dadurch gekennzeichnet, dass** die Modulation in diskontinuierlicher Weise angewandt wird, wobei die Wahl des Zeitintervalls zwischen zwei aufeinanderfolgenden Regelungen der Mikrowellensignalamplitude geleitet wird durch die Trägheit der Atomuhr gegenüber Störungen von deren Umgebung.

4. Verfahren nach einem der vorhergehenden Ansprüche, **dadurch gekennzeichnet, dass** für einen Resonator mit optischem Pumpen das Umwandlungsgesetz eine logarithmisches Gesetz ist.

5. Regelungsvorrichtung für die Durchführung eines Verfahrens nach den vorhergehenden Ansprüchen, umfassend einen ultrastabilen Oszillator (3) und eine Aufnahmeeinheit zur Berechnung und Steuerung (4), darauf ausgerichtet, Steuersignale (5, 15) zur Regelung des Mikrowellensignals auf der Atomresonanz ausgehend von der Antwort (Pₜ) des Resonators zu erzeugen, **dadurch gekennzeichnet, dass** sie Mittel zur Umwandlung (14) der Amplitude des Mikrowellensignals umfasst, das direkt von dem ultrastabilen Oszillator (3) kommt, damit die Antwortkurve (Pₜ) des Resonators symmetrisch in Abhängigkeit der Amplitude des Mikrowellensignals über eine weite Ausdehnung um die Vertikale herum ist, welche durch das Antwortmaximum verläuft.

6. Regelungsvorrichtung nach Anspruch 5, **dadurch gekennzeichnet, dass** sie Verstärkermittel (14) umfasst, die unter der Steuerung der Aufnahmeeinheit zur Berechnung und Steuerung (4) für die Korrektur eines Fehlers einstellbar ist, welcher aus der Anwesenheit von seitlichen Resonanzbanden kommt, welche die Atomresonanzbande umranden, die der Atomuhr als Referenz dient.

7. Vorrichtung zur Steuerung nach einem der Ansprüche 5 oder 6, **dadurch gekennzeichnet, dass** die obengenannten Mittel zur Umformung eine PIN-Diode im Fall eines Resonators mit Cäsiumstrahl bei optischem Pumpen umfassen.

## Claims

1. Process for controlling the amplitude of the microwave signal applied to an atomic clock of the type comprising an atomic resonator and an automatic control device for an ultrastable oscillator on the atomic resonance, which is adapted to generate the signal from which is derived said microwave signal, **characterised in that** the amplitude of the microwave signal (S), before it is applied to the atomic beam resonator (1), is converted according to a law such that the shape of the atomic response curve (Pₜ) as a function of the amplitude of the microwave signal (5) is symmetrical across a broad range around the vertical passing through the maximum of the response.

2. Process according to claim 1, **characterised in that** the modulation of the amplitude of the microwave signal (S) applied to the resonator (1) is deep, whereby the depth of modulation can be up to several db around the median value.

3. Process according to one of claims 1 or 2, **characterised in that** the modulation is applied discontinuously, the choice of the time interval between two successive adjustments of the amplitude of the microwave signal being guided by the inertia of the atomic clock relative to disturbances in its environment.

4. Process according to one of the preceding claims, **characterised in that** for an optical pumping resonator the conversion law is a logarithmic law.

5. Automatic control device for the performance of the process according to one of the preceding claims, comprising an ultrastable oscillator (3) and an acquisition, arithmetic and control unit (4) designed to generate control signals (5, 15) for the automatic control of the microwave signal on the atomic resonance based on the response (Pₜ) of the resonator, **characterised in that** it comprises a means (14) of converting the amplitude of the microwave signal derived directly from the ultrastable oscillator (3) in order that the response curve (Pₜ) for the resonator is symmetrical as a function of the amplitude of the microwave signal, across a broad range around the vertical passing through the maximum of the response.

6. Automatic control device according to claim 5, **characterised in that** it comprises a means of adjustable amplification (14), controlled by the acquisition, arithmetic and control unit (4), to correct an error arising from the presence of lateral resonance lines framing the atomic resonance line serving as a reference for the atomic clock.

7. Control device according to one of claims 5 or 6, **characterised in that** the aforementioned means of conversion comprises a PIN diode in the case of a caesium beam resonator with optical pumping.
